# EUROPÄISCHE PATENTANMELDUNG

(11) **EP 1 762 643 A2**
(43) Veröffentlichungstag der Anmeldung: **14.03.2007**
(21) Anmeldenummer: 06019094.9
(22) Anmeldetag: 12.09.2006
(51) Int. Cl.: C30B 15/20, C30B 15/30, C30B 29/22

(54) **Herstellung hochhomogener spannungsarmer Einkristalle durch Ziehen, eine Vorrichtung hierfür sowie die Verwendung solcher Kristalle**

(30) Priorität: 13.09.2005 DE 102005043623
(71) Anmelder: Schott AG, 55122 Mainz (DE)
(72) Erfinder: Wehrhan, Gunther, Dr., 07749 Jena (DE); Parthier, Lutz, Dr., 14532 Kleinmachnow (DE); Rytz, Daniel, Dr., 55758 Herborn (DE); Dupré, Klaus, Dr., 55743 Idar-Oberstein (DE); Ackermann, Lothar, Dr., 55743 Idar-Oberstein (DE)
(74) Vertreter: Fuchs Mehler Weiss & Fritzsche

(57) **Zusammenfassung**

Es wird ein Verfahren zur Herstellung von hochhomogenen, spannungsarmen Einkristallen mit einer vorgegebenen Kristallorientierung beschrieben. Der Kristall wird durch Eintauchen eines auf eine Temperatur unterhalb des Schmelzpunktes des Kristallrohmaterials gehaltenen Einkristalls in eine Schmelze und Züchten des Kristalls durch Herausziehen aus der Schmelze erhalten, wobei der Kristall und/oder die Schmelze mit einer regelbaren Rotationsgeschwindigkeit in einem Tiegelinnenraum relativ zueinander rotieren. Bei dem Verfahren wird eine ebene Phasengrenzfläche dadurch eingestellt, dass mindestens eine charakteristische Oberflächentemperatur im Tiegelinnenraum erfasst und bei Auftreten von Temperaturschwankungen diese durch Erhöhung oder Erniedrigung der Rotationsgeschwindigkeit ausgeregelt werden.Ein derart erhaltener Kristall weist einen Durchmesser von mindestens 50 mm auf und zeigt bei Betrachtung einer axial herausgeschnittenen Probe der Schichtdicke 2mm durch gekreuzte Polarisatoren bei normalem Weißlicht keine visuell sichtbaren Wachstumsstreifen im Fischgrätmuster. Solche Kristalle finden insbesonders als optische Elemente Verwendung.

## Beschreibung

Die Erfindung betrifft ein Verfahren zur Herstellung von hochhomogenen spannungsarmen Einkristallen mit einer vorgegebenen Orientierung durch Eintauchen eines Einkristalls in eine Schmelze und langsames Herausziehen des Kristalls unter kristalliner Erstarrung, eine Vorrichtung zur Durchführung des Verfahrens, die damit erhaltenen Kristalle sowie deren Verwendung.

Die Verwendung von kristallinem Material zur Herstellung von Linsen und optischen Elementen ist an sich bekannt. So werden insbesonders zur Herstellung von Integrierten Schaltkreisen mittels Photolithographie großvolumige Calciumfluorid-Einkristalle benötigt, welche mit kurzwelligem Licht bis zu einer Arbeitswellenlänge von ca. 130 nm durchlässig sind. Die Forderung nach immer höheren Integrationsdichten zieht eine weitere Miniaturisierung der Bauelemente nach sich und erfordert, im Prozess der Photolithographie immer kleinere Strukturen abzubilden. Aus diesem Grunde ist bereits vorgeschlagen worden, bei der Herstellung von Computerchips die aus der Mikroskopie bekannte Immersionstechnik anzuwenden. Dabei taucht das optische Element, durch welches das Projektionslicht aus dem Objektiv austritt, in eine Immersionsflüssigkeit ein. Auf diese Weise ist es möglich, den Öffnungswinkel zu erweitern und damit die Auflösung und die Tiefenschärfe zu erhöhen. Die Größe des jeweils realisierbaren Objektivöffnungswinkels ist jedoch von der Brechzahl dieser letzten Abschluss- oder Frontlinse im Projektionssystem abhängig. Die Brechzahl des CaF₂ von n = 1,5 kann die notwendigen Anforderungen des 32nm-Technologieknotens nicht erfüllen. Hochbrechende Kristalle, insbesonders Oxide der seltenen Erden, wie YAG, LuAG sowie GGG (Gadolinium-Gollium-Granat), die allesamt Brechzahlen von größer 1,75 aufweisen, kommen generell für solche Anwendungen in Frage. Derartige Kristalle dienen bei der Herstellung von Laserstäben als Wirtskristalle, indem sie bei der Zucht definiert dotiert werden. Die Laserstäbe von maximal 10mm Durchmesser werden aus spannungsarmen Bereichen des gezogenen Kristalles ausgebohrt. Da diese Laserstäbe die genannten geringen Abmessungen besitzen, reichen bereits Kristalldurchmessen von ca. 50mm aus. Zur Herstellung von Linsenblanks für den Einsatz in Projektionsobjektiven eines Steppers sind diese Abmessungen wesentlich zu klein und deren optische Qualität(Brechzahlhomogenität, Spannungsdoppelbrechung, DUV-Transmission) völlig unzureichend.

Die Herstellung derartiger Kristalle erfolgt üblicherweise durch Ziehen oder durch Eintauchen eines Kristallkeims in eine Schmelze aus Kristallrohmaterial und durch langsames Herausziehen des Keimes aus der Schmelze unter kristalliner Erstarrung. Eine üblicherweise im industriellen Maßstab angewandte Technik ist das sog. Czochralski-Verfahren, mit welchem bereits seit den 60er Jahren Einkristalle aus hochschmelzenden Oxiden, wie Saphir (Al₂O₃), Granaten, YAG (Y₃Al₅O₁₂) und Spinelle (MgAl₂O₄) hergestellt werden. Dabei werden bei Schmelztemperaturen bis über 2000°C die Kristalle in kommerziell erhältlichen Vorrichtungen aus Iridiumtiegeln gezogen.

Mit diesen Technologien ist es jedoch bislang nicht möglich, Kristalle zu erzeugen, die für optische Elemente in Lithographiesteppern benötigt werden. Diese optischen Elemente müssen Durchmesser von mindestens 100 mm, insbesonders mindestens 150-200 mm Durchmesser haben und gleichzeitig den notwendigen optischen Homogenitätsparametern wie spannungsinduzierter Doppelbrechung bei 193 nm von < 1 nm/cm und Brechzahlhomogenität von Δn < 1 ppm entsprechen.

Sollen gezüchtete Kristalle für die zuvor beschriebene Anwendung in der Photolithographie eingesetzt werden, müssen diese einen Durchmesser bis ca. 200 mm oder größer aufweisen und die zuvor geforderten optischen Homogenitätseigenschaften über mindestens 80% des Kristalldurchmessers und in einer Höhe des zylindrischen Gutkristalls von mindestens 100 mm in Ziehrichtung aufweisen. Nur so lassen sich z. B. Linsenblanks mit Durchmesser von ca. 150mm und einer Dicke von ca. 40mm aus dem gezüchteten Kristall herstellen. Darüber hinaus muss ein derartiger Kristall kostengünstig und mit hoher reproduzierbarer Qualität herstellbar sein.

Bei der Züchtung von Kristallen aus oxidischen Schmelzen nach dem Czochralski-Verfahren oder damit verwandten Verfahren, wie beispielsweise der sog. "Top Speed Solution Growth Technik" (TSSG), entstehen am wachsenden Kristall üblicherweise konvexe Wachstumskegel, welche in die Schmelze hineinreichen. Diese Kegel entstehen vor allem dadurch, dass die bei der Kristallisation frei werdende Energie über den Kristall abgeleitet wird. Die Krümmung der Wachstumsfront hängt somit von den thermischen Eigenschaften des Kristalls und der Schmelze sowie deren Wechselwirkungen miteinander ab.

Es ist nun bekannt, dass die im Tiegel vorliegende Schmelze einer Konvektionsströmung unterliegt, wobei die grundlegende oder freie Konvektion eine durch die Erwärmung mittels des an der Tiegelwand angeordneten Heizelementes erzeugte Auftriebskonvektion darstellt. Dabei steigt die erwärmte Schmelze an der geheizten Tiegelwand auf und sinkt leicht abgekühlt in die Mitte des Tiegels wieder nach unten. Auf diese Weise wird eine ringförmige, rotationssymmetrische, von außen nach innen gerichtete, freie Konvektion erzeugt. Andererseits wird durch den in die Schmelze hineinragenden, rotierenden Kristall der obere Teil der Schmelze mitgenommen und in eine mit der Rotation gleichgerichtete Drehbewegung gesetzt, wobei die am Kristall abgekühlte und damit dichtere Schmelze durch die erzeugten Zentrifugalkräfte zur Tiegelwand geleitet werden, dort absinken, bis sie durch die Strömung der freien Konvektion erfasst und wieder zur Tiegelmitte geleitet werden. Damit erzeugt der rotierende Kristall eine erzwungene Konvektion, die einen der zuvor beschriebenen freien, auftriebsgesteuerten Konvektion entgegengesetzten Verlauf aufweist. Erzwungene und freie Konvektion verlaufen bezogen auf den ebenen Tiegelquerschnitt in etwa spiegelsymmetrisch zueinander.

Derartige einander entgegengesetzt verlaufende Konvektionen und Strömungsregimes sind jedoch nicht stabil und insbesonders durch Änderungen der Temperaturverhältnisse im Tiegel oder der Rotationsgeschwindigkeiten leicht veränderbar. Die hieraus resultierenden Schwankungen bzw. Instabilitäten der Temperatur wirken sich direkt auf die Wachstumsvorgänge an der Phasengrenzfläche zwischen Kristall und Schmelze aus und führen zu Schwankungen in der Wachstumsgeschwindigkeit, die am fertigen Kristall einen störenden Streifenkontrast (Wachstumsstreifen oder Striae) hervorrufen. Solche Streifenkontraste werden durch Schwankungen der Gitterkonstanten und somit der Brechzahl hervorgerufen und beeinträchtigen die optische Homogenität des Kristalls. Sie sind mittels bekannten Nachweisverfahrens, wie beispielsweise durch Untersuchung zwischen gekreuzten Polarisatoren oder auch röntgenographisch ohne weiteres sichtbar.

Es hat sich nun gezeigt, dass die an den Phasengrenzflächen durch Kondensation freigesetzte Kondensationswärme auch zu Temperaturoszillationen und damit zu Wachstumsstreifen führt, die noch im fertigen Kristall sichtbar sind. Wird ein derartiger Kristall entlang seiner Mittelachse durchgeschnitten, dann sind durch Temperaturschwankungen jedwelcher Art hervorgerufene Wachstumsstreifen, sog. Striae (engl. Striations), insbesonders bei Betrachtung zwischen gekreuzten Polarisatoren Fischgrätmuster sichtbar. Wird nun aus einem solchen Kristall ein optisches Element, wie eine Linse, hergestellt, dann zeigt diese eine den Wachstumsringen eines Baumes ähnelnde ringförmige Anordnung von sich ändernden Brechungsindexes, weshalb eine derartige Linse für die zuvor genannten Anwendungen nicht mehr brauchbar ist. Derartige als Wachstumsstreifen bezeichnete Strukturdefekte entstehen selbst bei Einstoffsystemen, bei denen Verteilungs-Inhomogenitäten nicht auftreten. Es hat sich jedoch gezeigt, dass diese Streifenbildung durch Änderungen bzw. Fluktuationen in den Wachstumsbedingungen, insbesonders der Wachstumsgeschwindigkeit entsteht, die auf Schwankungen der Wachstumsgeschwindigkeit v und der fiktiven Diffusionsgrenzschichtdicke δ zurückzuführen ist, wobei der Diffusionskoeffizient jedoch konstant ist. Bei der Ausbildung derartiger Striae handelt es sich daher um komplexe, bislang nicht verstandene Fluktuationen in der Wachstumsgeschwindigkeit und den Transportvorgängen an der Wachstumsfront.

Es ist bislang nicht möglich, den Verlauf des Grenzbereiches zwischen natürlicher Konvektion und erzwungener Konvektion über die gesamte Zuchtdauer reproduzierbar einzuhalten. Überwiegt die natürliche Konvektion, entsteht eine konvexe Phasengrenze mit der Herausbildung von Wachstumsfacetten und der Neigung zu Wachstumsstreifen. Überwiegt die erzwungene Konvektion, entsteht die besonders unerwünschte konkave Phasengrenze mit allen negativen Auswirkungen auf Wachstumsdefekte.

Die nach dem Stand der Technik bisher praktizierte Steuerung von Abzugsgeschwindigkeit, Rotationsgeschwindigkeit und ggf. Heizleistung in Abhängigkeit des Kristallgewichtes reicht dafür nämlich nicht aus.

Es sind bereits vielfältige Versuche unternommen worden, die Homogenität von derart gezüchteten Kristallen zu verbessern. So beschreibt beispielsweise die DD 290 921 A5 eine Verbesserung der Homogenität von nach Czochralski hergestellten Granatkristallen, wenn diese derart gezüchtet werden, dass der Neigungswinkel der Phasengrenzfläche, bezogen auf die kristallographische (111)-Ebene, 44 +/- 5° oder 0 +/- 10° aufweist, wobei dieser Phasengrenzflächenneigungswinkel während des Züchtungsverlaufes durch Variation der Rotationsgeschwindigkeit konstant gehalten wird.

Die DE 390 59 66 A1 beschreibt die Züchtung von Kristallen nach der Czochralski-Methode für Laseranwendungen, und zwar insbesonders von Nd:YAG-Kristallen in der kristallographischen (100)- oder (111)-Richtung, bei der der Neigungswinkel der Phasengrenzfläche ≤ 35° für die (100)-Richtung und von 44 +/- 5° für die (111)-Richtung betragen soll. Auch hier soll der einmal eingestellte Neigungswinkel durch Variation der Rotationsgeschwindigkeit beibehalten werden. Diese Vorgehensweise wurde gewählt, da im damaligen Stand der Technik alle Versuche, eine ebene Phasengrenze einzustellen, als gescheitert angesehen wurden, da der Verlauf der Phasengrenze nicht reproduzierbar eingestellt werden konnte. Obwohl dieses Verfahren bereits eine Verbesserung von Inhomogenitäten ergibt, weisen derartige Kristalle dennoch bei weitem nicht die für optische Elemente notwendige Homogenität auf.

Die Erfindung hat daher zum Ziel, Kristalle, insbesonders hochschmelzende oxidische Kristalle bereitzustellen, welche die zuvor geschilderten Wachstumsstreifen, insbesonders solche mit einem Fischgrätmuster nicht oder in einem nicht störenden Umfang aufweisen. Dabei soll das Verfahren an einfach realisierbaren Apparaturen, die aus kommerziell erhältlichen Komponenten aufgebaut werden können, durchführbar sein. Darüber hinaus hat die Erfindung zum Ziel, ein Verfahren zur Züchtung verschiedener Kristalle mit großem Durchmesser bereitzustellen. Die Erfindung hat außerdem zum Ziel, ein derartiges Verfahren nach der Czochralski-Methode bereitzustellen.

Diese Ziele werden erfindungsgemäß mit den in den unabhängigen Ansprüchen definierten Maßnahmen erreicht. Vorteilhafte Ausgestaltungen sind in den Unteransprüchen angegeben.

Der Erfindung liegt nämlich die Erkenntnis zugrunde, dass Konvektionserscheinungen, wie sie bei erzwungener Konvektion auftreten(z. B. spiralförmige Arme), werden typischerweise von zusätzlichen, kleinen Konvektionswirbeln überlagert, die visuell nur schwach bzw. gar nicht mehr wahrgenommen werden können.

Es wurde nun gefunden, dass diese Konvektionswirbel Temperaturoszillationen hervorrufen, wodurch sich die mittlere Temperatur an der Oberfläche der Kristallschmelze ändert. Die Oberfläche strahlt somit unterschiedliche Wärme ab. Erfindungsgemäß wird diese Schwankung in der Wärmeabstrahlung der Oberfläche der Kristallschmelze detektiert und dient als Signal zum Regeln bzw. Steuern der Rotationsgeschwindigkeit des Kristalls , um das aus der Balance geratene Gleichgewicht von natürlicher und erzwungener Konvektion neu einzustellen.

Die Detektion der Wärmeabstrahlung von der Oberfläche der Kristallschmelze kann nun auf verschiedenem Wege erfolgen. Eine erste Möglichkeit besteht darin, oberhalb der Schmelze einen Temperatursensor (z. B. ein Thermoelement, ein Pyrometer oder eine Thermovisionskamera) anzubringen. Vorzugsweise wird der Temperatursensor auf der Oberseite einer zur Aufnahme des bereits fertig gezüchteten Kristalls oberhalb der Schmelze angeordneten Nachheizkammer angebracht.
Eine zweite Möglichkeit besteht darin, die Temperatur der Mantelfläche des aus der Schmelze herausgezogenen Kristalls anzumessen. Vorzugsweise wird dabei die Mantelfläche des gerade frisch gezüchteten Kristalls gemessen und zwar zweckmäßigerweise nahe der Schmelzoberfläche. In einer bevorzugten Ausführungsform wird die Temperatur der Kristalloberfläche bzw. deren Schwankungen innerhalb eines maximalen Abstandes von 150 mm, insbesondere maximal 100 mm, von der Schmelzoberfläche erfasst. Die Temperatur bzw. Schwankungen werden z. B. mittels eines Pyrometers oder einer Thermovisionskamera erfasst und erfolgt beispielsweise durch den Mantel der Nachheizkammer. Tritt nun eine detektierte Änderung oder Invariabilität der Oberflächentemperatur auf, dann wird erfindungsgemäß die Rotationsgeschwindigkeit entweder so lange erhöht oder so lange erniedrigt, bis wieder eine entsprechende Oberflächentemperatur erreicht wird. Eine entsprechende Temperatur ist dann erreicht, wenn diese der kontinuierlichen Entwicklung bzw. dem Trend entspricht. Es hat sich nämlich gezeigt, dass bei fortschreitender Zucht durch einen stetig zunehmenden Abstand von Sensor und Oberfläche der sich verbrauchenden Schmelze, der Basis- bzw. Mittelwert des Messsignals driftet, so dass die jeweilige entsprechende Oberflächentemperatur entlang der Driftkurve ohne weiteres eingestellt werden kann.

Auf diese Weise ist es möglich, auch große Kristalle insbesonders mit einer ebenen Wachstumsfront zu ziehen, bei der keine oder nur geringfügig feststellbare Wachstumsringe vorliegen. Vor allem zeigen die erfindungsgemäß hergestellten Kristalle keinerlei Fischgrätmuster, da bei der erfindungsgemäßen Vorgehensweise eine flache, ebene Wachstumsfront erzeugt wird.

Das erfindungsgemäße Verfahren wird vorzugsweise mit einem Nachheizsystem durchgeführt. Ein derartiges Tiegelnachheizsystem ist als eine Nachheizkammer über dem Schmelzraum analog eines Topfs angeordnet und dient der Aufnahme des bereits fertig gezogenen Kristallteils. Die Innenhaut dieses Nachheizsystem besteht vorzugsweise aus demselben Material wie der Tiegel, welcher die schmelzflüssige Kristallmasse aufnimmt. Es ist an seiner Außenseite thermisch isoliert, um Wärmeverluste zu verringern. Der Nachheizraum weist vorzugsweise während des Zuchtprozesses des Kristalls mit gewünschten großen Durchmesser eine möglichst hohe Temperatur auf, die einen möglichst geringen radialen und/oder axialen Temperaturgradienten erzeugt. Diese Temperatur beträgt > 1400°C, besser > 1600°C und besonders bevorzugt > 1800°C. Dies wird erreicht, indem die Nachheizkammer die Möglichkeit einer möglichst flächig homogenen Wärmezufuhr besitzt und erst auf diese Art zum Nachheizsystem wird. Auf diese Weise kann der Kristall direkt nach dem Ziehen ein Nachtempern von o.g. Temperatur auf Raumtemperatur hinunter erfahren, was zu einer weiteren Verringerung der spannungsinduzierten Doppelbrechung führt.

Während der Zucht bewirkt das homogene Temperaturfeld auf hohem Temperaturniveau eine zusätzliche Verringerung von Störeinflüssen für die Oberflächentemperatur der Schmelze und damit zu einer Reduzierung von Temperaturfluktuationen in der Schmelze bei den hier herrschenden hohen Temperaturen. Mittels der im Nachheizer herrschenden Temperatur ist es auch möglich, allein oder in Verbindung mit anderen Züchtungsparametern den Durchmesser des zu züchtenden Kristalls zu steuern.

Die Einstellung eines hohen Temperaturniveaus in der Nachheizkammer wird messtechnisch unterstützt, indem die bereits genannte zweite Möglichkeit der Temperaturmessung genutzt werden, bei der ein Pyrometer oder eine Thermovisionskamera durch eine Öffnung im Mantel der Nachheizkammer die Manteltemperatur des zylindrischen Kristalls misst. Diese Öffnung in der Nachheizkammer kann gleichzeitig Verwendung finden als Einlass von Inertgas während der Zucht bzw. des Nachtemperns. Die Zucht wird vorzugsweise unter Inertgas durchgeführt. Unter dem Einfluss von Inertgas wird auch während des Abtemperns der positive Effekt bzgl. der Verbesserung von Brechzahlhomogenität und Spannungsdoppelbrechung verstärkt. Die Zufuhr von Inertgas kann in Falle der Verwendung von Pyrometer bzw. Thermovisionskamera für die bereits genannte erste Methode der Temperaturmessung natürlich auch in gleicher Weise auch durch die Öffnung an der Oberseite der Nachheizkammer erfolgen.

Die für die Einstellung des Temperaturniveaus in der Nachheizkammer verwendete Temperaturmessung kann natürlich auch durch beabstandet an der Innenhaut der Nachheizkammer angebrachte Thermolemente(oben oder an der Mantelfläche) oder durch pyrometrisches Anmessen der Innenhaut der Nachheizkammer von außen erfolgen.

Die als Nachheizsystem ausgebildete Nachheizkammer, bietet einen zusätzlichen Vorteil, der darin besteht, zwischen Tiegel und Nachheizkammer eine Blende einzubauen, die eine Separierung beider Bereiche und eine separate Temperaturregelung beider Bereiche unter Einschränkung ihrer gegensetigen Beeinflussung zu ermöglichen. Im Bereich der Oberflächenbereiche des schmelzflüssigen Kristalls, deren mittlere Oberflächentemperaturänderungen zu Veränderungen messbarer Temperaturen an anmessbaren Orten führen, muss eine Öffnung in der Blende diese Wirkung jedoch noch zulassen.

Die bereits benannten, als kritisch bezeichneten und daher auszuregelnden, mittleren Temperaturveränderungen an der Oberfläche der Kristallschmelze werden vorzugsweise wie folgt bestimmt.

Verwendbare Temperatursensoren sind insbesonders Thermistoren oder Thermoelemente wie Thermopaare auf Basis des Seebeck-Effekts sowie Strahlungsthermometer (Pyrometer), insbesonders mit geeigneter Auswertung des integralen oder spektralen Strahlungsflusses (Strahlungsleistung), der von der Oberfläche eines erwärmten Körpers abgestrahlt wird, oder Strahlungssensoren (pyrometrische Sensoren), welche die direkte Strahlungswandlung an Bauelementen auf der Basis Festkörper physikalischer Effekte erfassen. Wesentlich für die vorliegende Erfindung ist, dass diejenige Wärme erfasst wird, welche von der Oberfläche der Schmelze abgestrahlt wird. Durch die erfindungsgemäße Erfassung der von der Oberfläche abgestrahlten Wärme folgt keine Störung des Wärmehaushalts von Kristall und Schmelze.

Werden erfindungsgemäß Thermoelemente oder Thermistoren eingesetzt, dann werden diese vorzugsweise auf der Außenseite des Nachheiztopfs angeordnet, welche der Schmelze gegenüber liegt. Zur Durchführung des erfindungsgemäßen Verfahrens ist eine exakte Messung der Temperatur nicht unbedingt notwendig. Vielmehr muss der eingesetzte Temperatursensor auch bei hohen Schmelztemperaturen von über 2000°C geringe Temperaturschwankungen von maximal +/- 5°C, insbesonders +/- 1°C und speziell maximal +/- 0,5°C bzw. +/- 0,1°C erfassen bzw. erkennen können.

Die Messung von Veränderungen der mittleren Temperatur an der Oberfläche der Kristallschmelze wird zweckmäßigerweise in Ergänzung bereits bekannter Temperaturmessungen durchgeführt. Bereits bekannt sind Temperaturmessungen an der Unterseite des Tiegels, welcher die schmelzflüssige Kristallschmelze enthält. Dies kann zum Beispiel auch über beabstandet angebrachte Thermoelemente geschehen. Eine Anmessung der Tiegelwandung mittels Pyrometers von unten ist genauso möglich. Möglich ist auch die pyrometrische Temperaturmessung der Temperatur der schmelzflüssigen Kristallmasse durch einen Saphierstab hindurch von oben oder von unten.

Für das erfindungsgemäße Verfahren geeignete Kristallmaterialien sind insbesonders Oxide, wie beispielsweise Oxide der seltenen Erden, und/oder Korundkristalle, Granate und Spinelle. Bevorzugte seltene Erden sind insbesonders YAG, LuAG und GGG. Besonders bevorzugte Materialien weisen bei der Zuchttemperatur eine Prandtl-Zahl von ca. 1 auf. Die Prandtl-Zahl ist eine dimensionslose Kennzahl eines Fluids und ist definiert als Verhältnis zwischen kinematischer Viskosität und thermischer Diffusivität. Das erfindungsgemäße Verfahren ist auch zur Herstellung von Kristallen geeignet, die zur Herstellung von Wafern für LED-Leuchtmittel Verwendung finden.

Mit dem erfindungsgemäßen Verfahren sind bei entsprechender Reinheit der Ausgangssubstanzen (mindestens 5N) ohne weiteres Kristalle mit einer Reinheit von sog. 5N (d. h. 5 Neuner), also von mindestens 99,999%-iger Reinheit herstellbar. Im Ausgangsrohstoff sind dabei Verunreinigungsgehalte an seltenen Erden und Alkalien besonders kritisch und daher zu vermeiden. Bevorzugt werden daher sogar Materialien mit einer Reinheit von 6N eingesetzt, um auch 6N Kristalle erhalten. Nach dem erfindungsgemäßen Verfahren sind auch großvolumige, dotierte Kristalle(z.B. Nd:YAG) in besserer Qualität und besserer Volumenausbeute herstellbar. Auch bei der Herstellung dotierter Kristalle, bei der zwar gegenüber der Herstellung undotierter Kristalle verstärkt Wachstumsstreifen auftreten können, kommt zum spürbaren Qualitätsvorteil noch ein hoher Effektivitätsvorteil durch gesteigerte Volumenausbeite beim Hersteller hinzu.
Auf diese Weise ist es auch möglich, mit dem erfindungsgemäßen Verfahren Laserstäbe mit Durchmesser größer 10mm herzustellen.

Die Erfindung soll an einem Beispiel näher erläutert werden.
Es zeigen
Fig. 1 eine schematische Darstellung der Kristallzüchtung nach dem Czochralski-Verfahren,
Fig. 2 einen entlang seiner Längsachse aufgeschnittenen Kristall gemäß dem Stand der Technik mit Fischgrätstriae (Fig. 2a) sowie einen erfindungsgemäß erhältlichen Kristall mit ebener Wachstumsfront und wenn überhaupt, dann nur schwach feststellbaren Wachstumsstreifen(Fig. 2b).
Fig. 3 einen erfindungsgemäß erhaltenen Kristall mit seinen verschiedenen Wachstumsphasen und
Fig. 4 die sichtbaren Konvektionserscheinungen (spiralförmige Arme) auf einer Oberfläche einer Schmelze bei der Kristallzucht, wobei t₁ - t₄ verschiedene Zeitpunkte des einmaligen Durchlaufens eines "Armes" bezeichnen (8 - 9 Durchläufe pro Minute)
Fig. 5 einen Querschnitt durch eine erfindungsgemäße Anordnung zur Kristallzucht und

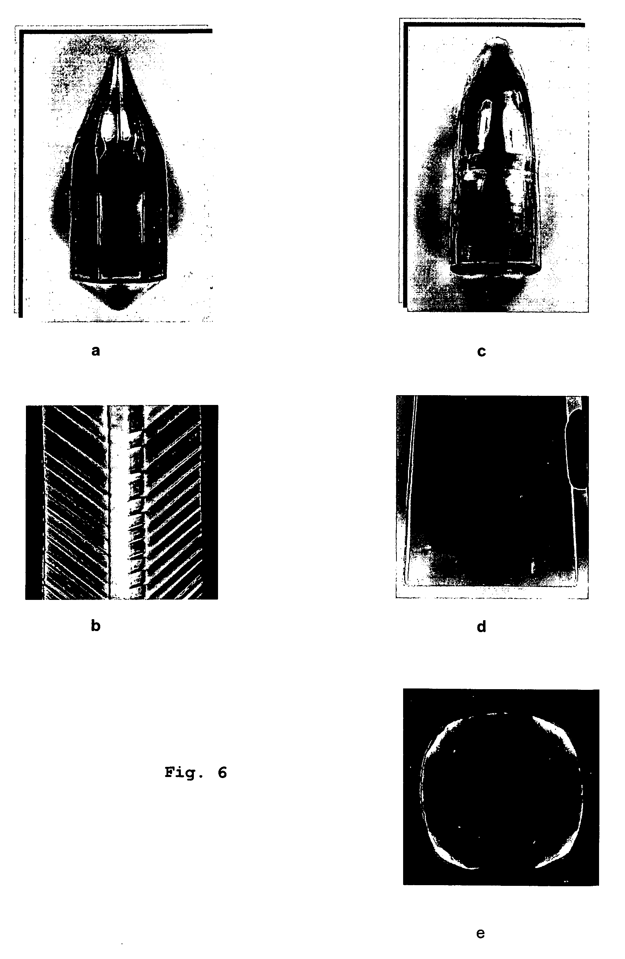

Fig. 6 einen Vergleich eines Kristalls gemäß dem Stand der Technik a - b und einen erfindungsgemäßen Kristall c - e jeweils zwischen gekreuzten Polarisatoren unter Weißlicht.

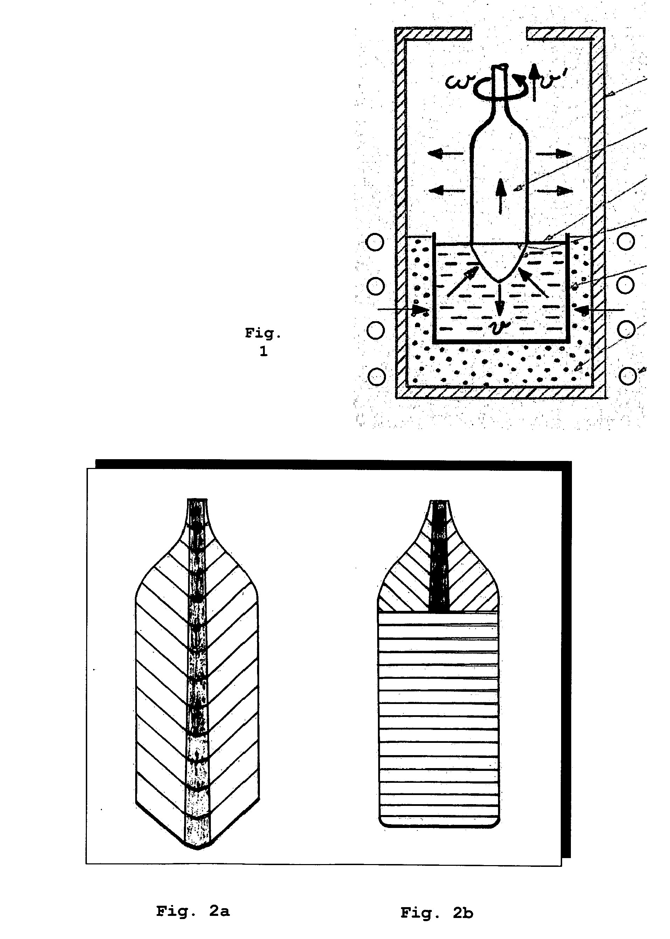

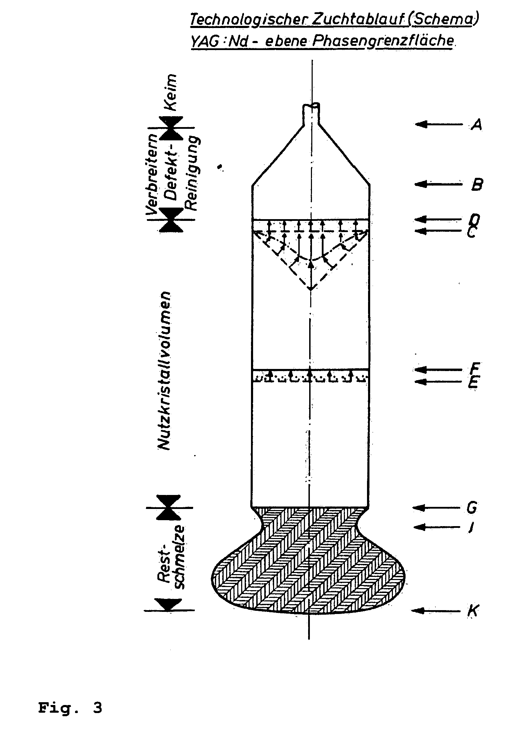

Bei dem erfindungsgemäßen Verfahren wird ein in Zielrichtung orientierter Keimkristall mit einem geringen Durchmesser in eine Schmelze aus Kristallrohmaterial, insbesonders eines hochreinen Materials, eingetaucht und unter Rotation durch langsames Ziehen in vertikaler Richtung unter Entzug von Wärme aus der Schmelze herausgezogen. Dabei erfolgt die Ziehgeschwindigkeit des rotierenden Kristallkeims zuerst derart, dass sich dieser vom geringen Ausgangsdurchmesser (Fig. 3a A) auf einen größeren gewünschten Ziehdurchmesser (Fig. 3a B) verbreitert. Ein derartiges Ziehen unter Verbreiterung des Durchmessers kann auch im erfindungsgemäßen Verfahren durchaus gemäß dem Stand der Technik mit einer konvexen, kegelförmigen Wachstumsfront erfolgen. Dabei ist es auch nicht notwendig, auf die Vermeidung von Temperaturoszillationen zu achten. In dieser Phase kann daher ohne weiteres der gezüchtete Kristall das Fischgrätmuster gemäß dem Stand der Technik aufweisen (Fig. 2b). Hat der Kristall den gewünschten Durchmesser erreicht (B), wird dieser bis auf eine Länge/Höhe weitergezüchtet, die zweckmäßigerweise mindestens ein Drittel, insbesonders mindestens jedoch die Hälfte und vorzugsweise jedoch mindestens das Einfache seines Durchmessers aufweist. Vorzugsweise weist der Kristall einen Durchmesser auf, der das 0,3 - 0,75-fache des Schmelztiegeldurchmessers beträgt. Besonders bevorzugt sind Werte von 0,4 - 0,6. Sobald der Kristall bis auf die oben angegebene Länge des zylindrischen Teils mit Zieldurchmesser gezogen worden ist, was gemäß dem Stand der Technik einfacherweise durch Bestimmen des Gewichts von Kristall und/oder Schmelze erfolgt, wird die Züchtung umgestellt und durch eine Erhöhung der Rotationsgeschwindigkeit und/oder einer geringförmigen zusätzlichen Wärmezufuhr die konvexe kegelförmige Wachstumsspitze eingeschmolzen und der gesamte Kristall entlang einem geringen Teil seiner bisher gezüchteten Höhe Δh zurückgeschmolzen. Das Rückschmelzen erfolgt z. B. bei Kristallen mit einem Durchmesser bis 50 mm, zweckmäßigerweise um Δh > 2mm, bei Kristallen mit größerem Zieldurchmesser z. B. bis 80 mm vorzugsweise um Δh > 5mm und bei Kristallen mit sehr großem Zieldurchmesser z. B. bis 120 mm und darüber üblicherweise um Δh > 10mm. Anschließend lässt man den Kristall gemäß dem erfindungsgemäßen Verfahren mit ebener Phasengrenzfläche gesteuert wachsen, wobei die Wärmeabstrahlung von der Oberfläche der schmelzflüssigen Kristallschmelze detektiert wird. Dass detektierte Messsignal zeigt im Idealfall dabei infolge Füllstandsabnahme einen sich stetig ändernden Verlauf. Weicht nun das detektierte Signal von dem sich normalerweise stetig änderndem Verlauf nach oben oder unten ab, wird die Rotationsgeschwindigkeit so weit erhöht oder erniedrigt, bis das detektierte Messsignal wieder auf der sich stetig ändernden Idealkurve liegt. Typische Änderungen der Rotationsgeschwindigkeit zur Ausregelung einer einzelnen Schwankung betragen dabei 0,01 bis 0,5 Umdrehungen/Min, wobei erfindungsgemäß eine Absolutdrehzahl von 5-10 im stationären Betrieb bei großen Kristallen zweckmäßig ist. Sollten bei der Zucht einmal stärkere Schwankungen auftreten, so ist es erfindungsgemäß ohne weiteres möglich, die hierbei erzeugten Kristallfehler durch ein kontrolliertes Zurückschmelzen wieder zu beheben. Die erfindungsgemäße Züchtung des Kristalls erfolgt vorzugsweise in der (100)-Richtung, prinzipiell ist es jedoch auch möglich, in (111)-Richtung zu ziehen.

Durch die erfindungsgemäße Vorgehensweise wird das komplexe System der Steuerung des Kristallherstellungsprozesses in (teilweise vorstehend bereits beschriebene) Prozessphasen (siehe Fig. 3) zerlegt. Die Richtungen von einzelnen oder mehreren Konvektionsströmungen innerhalb der Kristallschmelze werden in den einzelnen Prozessphasen in zeitlich abgestimmter Reihenfolge definiert unterschiedlich gestaltet. Zwischen den einzelnen Prozessphasen bzw. Änderungen von Verfahrensparametern wird erfindungsgemäß eine kurze Ausgleichspause von mindestens 60 sec, vorzugsweise mindestens 2, insbesonders mindestens 3 Min eingelegt, um das thermische System Schmelze/Kristall in einem quasi stationären Gleichgewichtszustand zu bringen, bis die Messsignale wieder konstante Werte annehmen. Vorzugsweise wird bei der erfindungsgemäßen Vorgehensweise beim Übergang von einer Prozessphase zur nächsten immer nur ein Parameter gleichzeitig geändert, d. h. Temperatur der Schmelze, Temperatur des Nachheizers, Heizleistung, Zieh- und/oder Rotationsgeschwindigkeit. Müssen beim Übergang von einer Prozessphase zur nächsten doch mehrere Parameter geändert werden(z.B. Q - Rückschmelzen), so erfolgt dies nacheinander und immer erst nachdem sich nach der ersten Veränderung ein neuer stationärer Zustand eingestellt hat. Während der Züchtung des Nutzkristallvolumens kann sich eine geringfügige Nachführung der Heizerleistungen als vorteilhaft erweisen.

Der Kristall von Fig. 3 wurde wie folgt gezüchtet.

Ausgehend von den Bedingungen unter (A) wurde der Kristalldurchmesser auf die gewünschte Größe aufgeweitet und der Kristall im Strömungsregime der freien Konvektion gezüchtet. Am Ende wird bei (B) der Kristallhub angehalten und die momentane Heizleistung konstant gehalten. Anschließend wird in einem weiteren Teilschritt die Kristallrotation auf eine Geschwindigkeit erhöht, die zu jedem Zeitpunkt der Rotationserhöhung die Ausbildung eines jeweiligen Gleichgewichtzustands zwischen Schmelze und Kristall zulässt. Diese Rotationserhöhung ist bei (C) erreicht. Bei diesem Wert wird eine durch Rotation erzwungene Konvektion erreicht, bei der die Phasengrenzfläche eingeebnet ist. Dieser Wert kann auf 0,5 Umdrehungen/Min genau aus dem charakteristischen Verlauf der Messsignale ,Kristallgewicht' und ,Wärmeabstrahlung von der Oberfäche der schmelzflüssigen Kristallmasse' bestimmt werden. Ist dieser kritische Drehzahlwert für die erzwungene Konvektion erreicht, dann wird nach erneutem Abwarten des Gleichgewichts die Kristalldrehzahl (D) soweit erhöht, dass sich die erzwungene Konvektionsströmung stabilisiert und unerwünschte Übergänge zwischen erzwungener und freier Konvektionsströmung im gesamten Zuchtverlauf sowie störende Temperaturoszillationen vermieden werden. Dies ist dann beim Teilschritt (E) beendet. Nach Teilschritt (E-F) erfolgt ein Rückschmelzen des Kristalls in einem geringfügigen Umfang, d. h. ≤ 1 mm. Durch dieses Rückschmelzen werden in vorangegangenen Teilschritten erzeugte Wachstumsstörungen beseitigt, und in unmittelbarer Umgebung der Phasengrenzfläche wird eine Verdünnung an Verunreinigungen bzw. Dotierungsstoffen mit K < 1 erreicht. Hierdurch wird ein verzögerter Anlauf der effektiven Wachstumsgeschwindigkeiten möglich. Anschließend wird der Kristallhub eingeschaltet und die Züchtung unter den Bedingungen der erzwungenen Konvektionsströmung bis zum Ende fortgeführt. Typische Rotationsgeschwindigkeiten betragen für die erfindungsgemäße Kristalle mit einem Durchmesser von vorzugsweise mindestens 80 mm ca. 5 Umdrehungen/Min zur Aufweitung des Durchmessers, zum Abflachen der Kegelspitze ca. 15 Umdrehungen/Min und sinken im Laufe der Züchtung auf ca. 10 Umdrehungen/Min ab. Gegen Ende der Zucht beträgt die Rotation oft nur noch ca. 5 Umdrehungen/Min.

Bei der erfindungsgemäßen Vorgehensweise wird vorzugsweise nach dem Erreichen der erzwungenen Konvektion in der Schmelze der Kristall auf dem gleichen Durchmesser weiter gezogen, ohne dass dabei eine Veränderung in der Heizleistung erfolgt (geringfügige Nachführung der Heizleistung ist möglich). Es hat sich gezeigt, dass mittels des erfindungsgemäßen Verfahrens statistische und unregelmäßig auftretende Temperaturfluktuationen, sog. stochastische Temperaturfluktuationen, welche zu lokalen Wachstumsstörungen führen, verhindert werden können. Derartige Kristallstörungen sind im erfindungsgemäßen Verfahren allerdings ohne weiteres durch Rückschmelzen und einer damit hergehenden Defektlöschung wieder zu beseitigen.

Das erfindungsgemäße Verfahren wird insbesonders in solchen Czochralski-Vorrichtungen durchgeführt, die ein Tiegelnachheizsystem aufweisen, in dem der gezogene Einkristall bis zum Ende des Züchtungsprozesses verbleibt. Derartige Tiegelnachheizräume sind vorzugsweise thermisch gut isoliert. Prinzipiell wird während der Züchtung und im Nachheizraum ein möglichst homogener radialer und/oder axialer Temperaturgradient aufrechterhalten. Besonders bewährt hat sich ein über den eigentlichen Züchtungstiegel angeordneter Edelmetallzylinder (z.B. aus Iridium) erwiesen, der sowohl eine starke Reduzierung des axialen Temperaturgradienten als auch eine Verhinderung der Temperaturfluktuation bewirkt. Im erfindungsgemäßen Verfahren ist es bevorzugt, zusätzliche Temperaturmessungen am Nachheizer und/oder am Tiegelboden über dort angeordnete Abstandstifte, insbesonders aus Iridium oder einem anderen Tiegelmaterial, bzw. mittels Hochtemperatur-Edelmetall-thermoelementen vorzunehmen. Mit derartigen Thermoelementen ist eine ausgezeichnete Registrierung relativer Temperaturschwankungen im Schmelzvorgang und insbesonders an der Schmelzoberfläche möglich.

In einer bevorzugten Ausführungsform wird zur Erreichung hoher Homogenität maximal 50%, insbesonders maximal 45% des Schmelzvolumens für die eigentliche Kristallzüchtung verwendet, da bereits geringste Verunreinigungen mit einem Verteilungskoeffizienten von k << 1 aufgrund ihrer Konzentrationsanreicherung im unteren Teil des Kristalls zu Inhomogenitäten führen können. In einer ganz bevorzugten Ausführungsform wird daher lediglich maximal 40%, insbesonders maximal 35% des Schmelzvolumens zur Kristallzüchtung genutzt, wobei in Einzelfällen sich maximale Mengen von nur 30% als zweckmäßig erwiesen haben.

In einer erfindungsgemäßen bevorzugten Vorgehensweise wird gegen Ende der Kristallzüchtung durch eine Erhöhung der Ziehgeschwindigkeit der Kristalldurchmesser zuerst auf ein Minimum verringert (typischerweise auf 5 - 15%) und dann unter Verbreiterung die Restschmelze aus dem Schmelztiegel herausgezogen. Da nach Abschluss des Leerziehens der Nutzkristalle mit dem daran hängenden, knollenförmigen Schmelzrests innerhalb der Tiegel- und Nachheizerkonfiguration verbleibt und dort kontrolliert in der üblichen Weise bis auf Raumtemperatur abgekühlt wird, wird ein negativer Einfluss des Schmelzrests auf die Qualität der Realstruktur des Kristalls vermieden. Diese Maßnahme führt jedoch nicht nur zu einer Verbesserung der Kristallhomogenität sondern auch zu einer Erhöhung der Lebensdauer der Zuchttiegel, da diese nicht mehr durch ein mechanisches Herausstemmen von der erstarrten Restkristallschmelze befreit werden müssen. Damit ist es erfindungsgemäß auch möglich, Züchtungstiegel aus Rhenium anstatt aus Iridium zu verwenden. Für die Weiterverwendung nicht benötigte und unbrauchbare Knollen der Restschmelze lässt sich ohne weiteres mittels eines Hammerschlags entfernen.

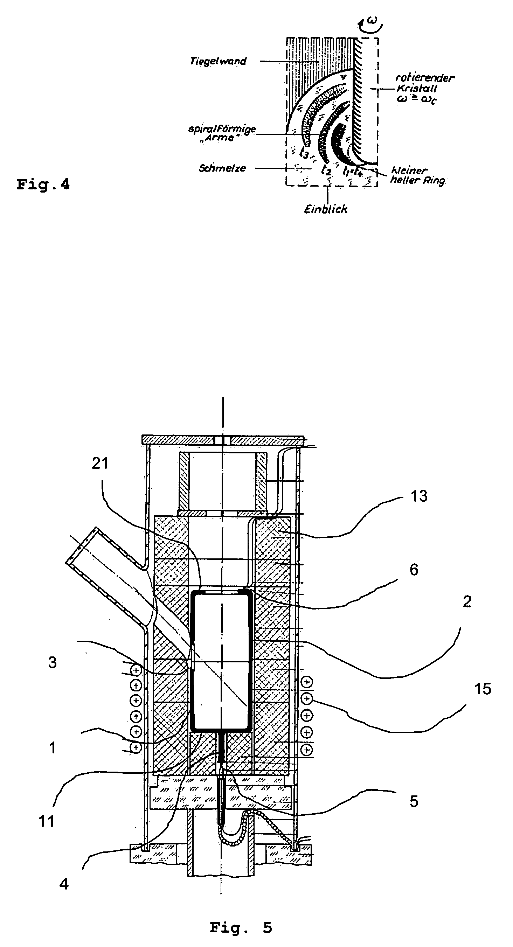

Die Erfindung betrifft auch eine Vorrichtung zur Herstellung solcher Kristalle, wie sie beispielsweise in Fig. 5 dargestellt ist. Dabei wird ein Zuchttiegel (1) von einer darüber angeordneten Nachheizeinrichtung, z. B. ein Nachheiztopf (2), der vorzugsweise aus Edelmetall besteht, abgedeckt. Zweckmäßigerweise weist der Tiegel (1) oder Topf (2) eine seitliche Öffnung (3) auf, über die der Zuchtprozess von außen beobachtet werden kann. Tiegel und Topf wird ringsum von einem Isolationsmaterial (13) umgeben und werden üblicherweise beide mittels einer Induktions- und/oder Widerstandsheizung (15) beheizt. Bevorzugtes Isolationsmaterial besteht aus keramischem Material, insbesonders in Form von Fasermatten. Auch Steinwolle kann verwendet werden. An seiner unteren Seite (11) weist der Schmelztiegel einen daran angeordneten Stift (4) auf, der vorzugsweise aus dem gleichen Material wie der Tiegel (1) besteht und der vom Tiegel (1) beabstandete Messelemente und Temperatursensoren (5) aufweist, über welche die Temperaturen und Temperaturänderungen in der Schmelze genau verfolgt werden können. Ein derartiger Stift (4) wirkt auch als Wärmesenke, welche die auftriebsgesteuerte, freie Konvektion in der Schmelze und damit ihre Durchmischung fördert. Die erfindungsgemäße Anordnung zeichnet sich nun dadurch aus, dass diese an ihrer oberen Seite am Nachheizer (2) einen Thermosensor (6) aufweist, der die von der Schmelzoberfläche ausgehende Wärmestrahlung erfasst. Ein derartiger Wärmesensor (6) kann beispielsweise eine an der äußeren Seite (21) des Nachheiztopfs (2) angeordnete Thermoperle (6) sein. Eine derartige Thermoperle erfasst die von der Topfoberseite aufgenommene Strahlungswärme. Zweckmäßige Strahlungsempfänger sind Thermoelemente wie beispielsweise eine Thermoperle. Prinzipiell können diese jedoch auch Thermoresistoren sein oder auch Pyrometer etc., wie z. B. ein Infrarotsensor, der die Temperaturschwankungen der Schmelzoberfläche erfasst.

Die Nachheizeinrichtung (2) weist in einer bevorzugten Ausführungsform zur Minimierung von Temperaturschwankungen eine Signalverarbeitungseinheit (nicht dargestellt) auf, die beispielsweise von einem elektronischen vier Punkte Temperaturregler oder auch einem Rechner gesteuert wird, der die Temperatur im Nachheizer regelt. Damit ist es erfindungsgemäß auch möglich, eine derartige Temperaturmessung im Nachheizer zur Steuerung des Kristalldurchmessers zu verwenden.

In einer besonders bevorzugten Ausführungsform wird der Temperatursensor, beispielsweise die Perle eines Thermoelements an der oberen Seite der Außenwand der Nachheizeinrichtung anlegiert. Durch diese besondere geometrische Position befindet sich der Thermosensor in einem ausreichenden Abstand zur heißen Schmelze, wodurch ein genügend großer Temperaturabfall von der Schmelze (ca. 2000°C) bis zur Temperaturmessstelle (T ca. 1650°C) gegeben ist. Bei einer Schmelztemperatur der beispielsweise für ein Thermoelement verwendeten Legierung (beispielsweise ca. 1800°C) ist dieses vor rascher thermischer Zerstörung geschützt. Aus diesem Grunde verzögert sich die solchen Thermoelementen eigene, dem Fachmann bekannte Alterung. Der Thermosensor misst die von der Wand des Nachheizsystems zugeleitete Wärmeenergie, die im Wesentlichen die von der Schmelzoberfläche imitierte Strahlungsenergie ist. Ein Teil dieser Energie wird von einer begrenzten Fläche der Nachheizerinnenwand von dem rückseitig angeordneten Sensor absorbiert und kann so bestimmt werden. Durch diese erfindungsgemäße Vorgehensweise ist es möglich, bereits bestehende oder auch kommerziell erhältliche Zuchtanlagen mit geringem Aufwand so auszurüsten, dass diese für das erfindungsgemäße Verfahren geeignet sind. Die erfindungsgemäße Vorgehensweise stellt eine sichere Erfassung der Temperatur eines Teils der Schmelze, d. h. deren Oberfläche sicher, die auch noch bei Änderungen im Züchtungsprozess wie dem Absenken der Schmelzhöhe durch Verbrauch des Materials oder einer Änderung des Strömungsregimes noch sicher und eindeutig bestimmbar sind.

Die Erfindung betrifft jedoch auch derartige, mit dem erfindungsgemäßen Verfahren erhaltene Kristalle. Bevorzugte erfindungsgemäße Kristalle sind insbesonders kubische Granate, kubische Spinelle, kubische Perskitte und/oder kubische II/IV-Oxide, sowie hochkristallines Silizium, Korund-Einkristalle. Bevorzugte Kristalle sind insbesonders Granate der allgemeinen Formel:

(A₁₋ₓDₓ)₃Al₅O₁₂,

wobei D ein mit A³⁺ bezüglich Valenz und Ionenradius ähnliches Element ist, um die Gitterverzerrungen so gering wie möglich zu erhalten. Erfindungsgemäß bevorzugte Elemente A sind insbesondere Yttrium, seltene Erden bzw. Lanthanide, d. h. Ce, Pr, Nd, Pm, Sm, Eu, Gd, Tb, Dy, Ho, Er, Tm, Yb, und/oder Lu, sowie Scandium, wobei die Elemente Y, Lu, Yb, Tm, und Dy sowie Sc besonders bevorzugt sind. Geeignete Vertreter des Dotierungsmittels D sind ebenfalls ausgewählt aus der Gruppe umfassend Yttrium, seltene Erden, sowie Scandium. Als besonders zweckmäßig haben sich mit anderen seltenen Erden und/oder Sc dotierte Granate vom Typ Y₃Al₅O₁₂, Lu₃Al₅O₁₂, Dy₃Al₅O₁₂, Tm₃Al₅O₁₂, Yb₃Al₅O₁₂, erwiesen und speziell ein Mischkristall aus (Y₁₋ₓLuₓ)₃Al₅O₁₂.

x bedeutet den Molenbruch mit 0 ≤ x ≤ 1. Vorzugsweise sind A und D verschieden. Für den Fall, dass A und D gleich sind, ist x = 0. Der Kristall ist dann nicht dotiert. Erfindungsgemäß werden vorzugsweise solche Molenbrüche verwendet, welche für Schmelze und Kristall gleich sind, d. h. solche Molenbrüche, bei denen sich die prozentuale Zusammensetzung beim Auskristallisieren nicht ändert. Sofern erfindungsgemäße optische Elemente hergestellt werden sollen, welche eine Zusammensetzung aufweisen, in der sich das Material in einer anderen Zusammensetzung auskristallisiert als derjenigen der Schmelze, dann ist es erfindungsgemäß selbstverständlich ohne weiteres möglich, durch laufende Zugabe des in der Schmelze abgereicherten Bestandteils, deren prozentuale Zusammensetzung und damit den Molenbruch im festen Kristall über die gesamte Zucht konstant zu halten.

Von den kubischen Spinellen haben sich insbesonders Spinell MgAl₂O₄, Ghanospinell (Mg, Zn)Al₂O₄, CaAl₂O₄, CaB₂O₄ und/oder Lithiumspinell LiAl₅O₈ als besonders geeignet erwiesen.

Von den kubischen Perovskiten sind BaZrO₃ und/oder CaCeO₃ besonders bevorzugt, und von den kubischen II/VI-Oxiden sind insbesonders (Mg, Zn)O geeignet.

Die erfindungsgemäßen Kristalle zeichnen sich insbesonders durch einen Durchmesser von mindestens 50 mm aus, vorzugsweise mindestens 100 mm, wobei Mindestgrößen von 120, insbesonders mindestens 150 mm besonders bevorzugt sind. Ganz besonders bevorzugt sind solche erfindungsgemäßen Kristalle mit einem Durchmesser von mindestens 160, insbesonders mindestens 180mm, wobei solche mit einem Mindestdurchmesser von mindestens 200 mm noch mehr bevorzugt sind.

Die erfindungsgemäßen Kristalle mit einem Durchmesser von mindestens 50mm weisen bei Betrachtung einer axial herausgeschnittenen Probe der Schichtdicke 2mm durch gekreuzte Polarisatoren bei normalem Weißlicht keine visuell sichtbaren Wachstumsstreifen im Fischgrätmuster auf, und vorzugsweise auch keine im wesentlichen horizontalen Wachstumsstreifen auf.

Vorzugsweise weisen sie außerdem bei Betrachtung einer 2mm dicken Scheibe und bei Betrachtung in Aufwachsrichtung in einem Mittenbereich von 80% des Durchmessers keine ringförmigen hellen bzw. dunklen Bereiche auf, sondern zeigen maximal nur schattenartige Helligkeitsunterschiede.

Für die erfindungsgemäßen Kristalle mit einem Durchmesser von mindestens 50mm beträgt im Mittenbereich von 80% ihres Durchmessers in Aufwachsrichtung bestimmt die Spannungsdoppelbrechung bei 193 nm < 1 nm/cm sowie die Brechzahl-Homogenität Δn < 1 ppm. Ganz besonders bevorzugt sind nicht dotierte Kristalle.

Die erfindungsgemäßen Kristalle weisen vorzugsweise eine Reinheit von mindestens 99,999%, insbesonders mindestens 99,9999%, auf. Darüber hinaus zeigen sie eine Orientierung in Zuchtrichtung von (100) oder (111).

Die Erfindung betrifft somit auch die Verwendung von erfindungsgemäßen Kristallen bzw. mit dem erfindungsgemäßen Verfahren erhaltene Kristalle zur Herstellung von Linsen, Prismen, Laserstäben, optischen Fenstern sowie optischen Komponenten für die DUV-Fotolithografie, Steppern, Lasern, insbesondere von Excimer-Lasern, Computerchips, sowie integrierten Schaltungen und elektronischen Geräten, die solche Schaltungen und Chips enthalten. Die Erfindung betrifft auch die Verwendung der Kristalle für die Herstellung von Waferns für LED's und für die Photovoltaik.

## Patentansprüche

1. Verfahren zur Herstellung von hochhomogenen, spannungsarmen Einkristallen mit einer vorgegebenen Kristallorientierung aus einer eine Oberfläche aufweisenden Schmelze durch Eintauchen eines auf eine Temperatur unterhalb des Schmelzpunktes des Kristallrohmaterials gehaltenen Einkristalls in die Schmelze unter Ausbildung einer Phasengrenzfläche fest-flüssig und Züchten des Kristalls durch Herausziehen aus der Schmelze entlang der vorgegebenen Kristallorientierung vertikal zur Schmelzoberfläche unter Ableitung von Wärme, wobei der Kristall und/oder die Schmelze mit einer regelbaren Rotationsgeschwindigkeit in einem Tiegelinnenraum relativ zueinander rotieren,
**dadurch gekennzeichnet, dass** eine ebene Phasengrenzfläche dadurch eingestellt wird, dass mindestens eine charakteristische Oberflächentemperatur im Tiegelinnenraum erfasst und bei Auftreten von Temperaturschwankungen diese durch Erhöhung oder Erniedrigung der Rotationsgeschwindigkeit ausgeregelt werden.

2. Verfahren nach Anspruch 1, **dadurch gekennzeichnet, dass** eine charakteristische Oberflächentemperatur die Oberflächentemperatur der Schmelze ist.

3. Verfahren nach Anspruch 1, **dadurch gekennzeichnet, dass** eine charakteristische Oberflächentemperatur die Oberflächentemperatur eines zylindrischen Teiles des gezogenen Kristalls ist.

4. Verfahren nach einem der vorhergehenden Ansprüche, **dadurch gekennzeichnet, dass** die charakteristische Oberflächentemperatur über die davon abgestrahlte Wärmeenergie bestimmt wird.

5. Verfahren nach einem der vorhergehenden Ansprüche, **dadurch gekennzeichnet, dass** mindestens eine charakteristische Oberflächentemperatur mittels eines Thermosensors erfasst wird.

6. Verfahren nach einem der vorhergehenden Ansprüche, **dadurch gekennzeichnet, dass** die charakteristische Oberflächentemperatur mittels eines von der Schmelzoberfläche beabstandeten Sensores erfasst wird.

7. Verfahren nach einem der vorhergehenden Ansprüche, **dadurch gekennzeichnet, dass** die vorgegebene Kristallorientierung mittels eines Superkeimes erzeugt wird, der bereits einen Durchmesser aufweist, der demjenigen des zu züchtenden Kristalls entspricht.

8. Verfahren nach einem der vorhergehenden Ansprüche, **dadurch gekennzeichnet, dass** der eingetauchte Kristall und/oder Kristallkeim vor Beginn der Züchtung zurückgeschmolzen wird.

9. Verfahren nach einem der vorhergehenden Ansprüche, **dadurch gekennzeichnet, dass** der Kristall den 0,3 bis 0,8-fachen Durchmesser der in einem Tiegel vorliegenden Schmelze aufweist.

10. Verfahren nach einem der vorhergehenden Ansprüche, **dadurch gekennzeichnet, dass** maximal 40% der anfangs vorliegenden Schmelzmasse zur Kristallzüchtung verwendet werden.

11. Verfahren nach einem der vorhergehenden Ansprüche, **dadurch gekennzeichnet, dass** nach Beendigung des Zuchtvorgangs die Restschmelze unter Verringerung des Kristalldurchmessers mit anschließender Verbreiterung unter kristalliner Erstarrung aus dem Schmelztiegel entfernt wird.

12. Verfahren nach einem der vorhergehenden Ansprüche, **dadurch gekennzeichnet, dass** nach Beendigung des Zuchtvorganges und Entfernen der Restschmelze aus dem Tiegel der Kristall in einer Nachheizkammer definiert abgetempert wird.

13. Verfahren nach einem der vorhergehenden Ansprüche , **dadurch gekennzeichnet, dass** Tiegelinnenraum und Nachheizer während des Zucktprozesses und/oder während des Abtemperns mit Inertgas gespült werden.

14. Vorrichtung zum Züchten von Kristallen nach dem Czochralski-Verfahren, umfassend einen Schmelztiegel zur Aufnahme einer Kristallschmelze, eine diesen umgebende Isolation sowie Heizelemente zum Aufschmelzen, eine Halterung zum Heben eines zu züchtenden Kristalls, wobei Halterung und/oder Schmelztiegel um eine vertikale Achse rotierbar gelagert sind, **dadurch gekennzeichnet, dass** die Vorrichtung mindestens einen Temperatursensor zum Erfassen einer für die Kristallschmelze charakteristischen Temperatur aufweist.

15. Vorrichtung nach Anspruch 14, **dadurch gekennzeichnet, dass** der Tiegel an seinem Boden einen Metallstift aufweist, an dessen Ende ein weiterer Temperatursensor angebracht ist.

16. Vorrichtung nach Anspruch 14, **dadurch gekennzeichnet, dass** sie eine Nachheizkammer aufweist, auf deren Oberseite ein weiterer Temperatursensor angeordnet ist.

17. Vorrichtung nach Anspruch 14, **dadurch gekennzeichnet, dass** die Nachheizkammer einen Mantel aufweist, an dem ein weiterer Temperatursensor angeordnet ist.

18. Vorrichtung nach einem der Ansprüche 14 - 17, **dadurch gekennzeichnet, dass** der Temperatursensor eine Thermoperle, ein Pyrometer und/oder eine Thermovisionskamera ist.

19. Spannungsarmer Kristall, erhältlich nach den Verfahren nach einem der Ansprüche 1 bis 13, **dadurch gekennzeichnet, dass** er einen Durchmesser von mindestens 50 mm aufweist und bei Betrachtung einer axial herausgeschnittenen Probe der Schichtdicke 2mm durch gekreuzte Polarisatoren bei normalem Weißlicht keine visuell sichtbaren Wachstumsstreifen im Fischgrätmuster aufweist.

20. Kristall entsprechend Anspruch 19, **dadurch gekennzeichnet, dass** er in einem Mittenbereich von 80% des Durchmessers eine Spannungsdoppelbrechung bei 193 nm und bei Bestimmung in Aufwachsrichtung von < 1 nm/cm sowie eine Brechzahl-Homogenität Δn < 1 ppm aufweist.

21. Kristall nach einem der Ansprüche 19 - 20, **dadurch gekennzeichnet, dass** er ein undotierter Granat ist.

22. Verwendung von nach dem Verfahren der Ansprüche 1 bis 13 erhaltenen Kristallen sowie den Kristallen nach Anspruch 19 - 21 zur Herstellung von Linsen, Prismen, optischen Fenstern, Laserstäben sowie optischen Komponenten für die DUV-Lithographie, Steppern, Excimer-Lasern, Computerchips sowie integrierten Schaltungen und elektronischen Geräten, die solche Chips enthalten sowie als Wafer für LED's und für die Photovoltaik.
